# EUROPEAN PATENT APPLICATION

(11) **EP 2 207 215 A2**
(43) Date of publication of application: **14.07.2010**
(21) Application number: 09176953.9
(22) Date of filing: 24.11.2009
(51) Int. Cl.: H01L 41/24

(54) **Method of Poling Ferroelectric Materials**

(30) Priority: 12.01.2009 GB 0900406
(71) Applicant: Delphi Technologies Holding S.à.r.l., 4940 Bascharage (LU)
(72) Inventor: Gris, Christian, 41350, St. Claude De Diray (FR); Berlemont, Jean-Francois, B-1860 Meise (BE); Vendulet, Joachim, 67700, Niederkirchen (DE); Panteny, Simon, Gillingham, Kent ME7 2QE (GB)
(74) Representative: Gregory, John David Charles

(57) **Abstract**

A method of poling a ferroelectric sample (2a) suitable for use in a fuel injector (5) of an internal combustion engine, the method comprising providing a ferroelectric sample (2a) having a stack of ferroelectric layers (4), wherein adjacent layers (4) are separated by internal electrodes (6a, 6b), forming a first group (6a) and a second group (6b) of electrodes; applying a multiaxial pressure to the ferroelectric sample; reducing the bonding strength between each pair of adjacent ferroelectric layers and internal electrodes; and generating a first electric field between the first (6a) and second (6b) group of electrodes to pole each ferroelectric layer (4) in a first poling direction.

## Description

### Technical Field

The present invention relates to a method of poling a sample of ferroelectric material, comprising a plurality of ferroelectric layers arranged in a stack, so as to induce bulk piezoelectricity. In particular, but not exclusively, the invention relates to a method of poling multilayer ferroelectric samples of the type suitable for use in piezoelectric actuators for fuel injection systems for internal combustion engines.

### Background to the Invention

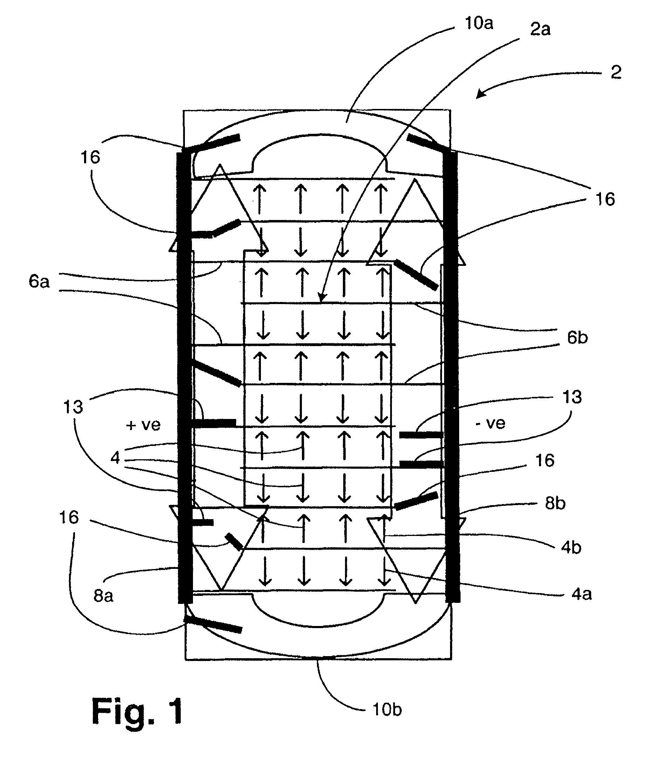

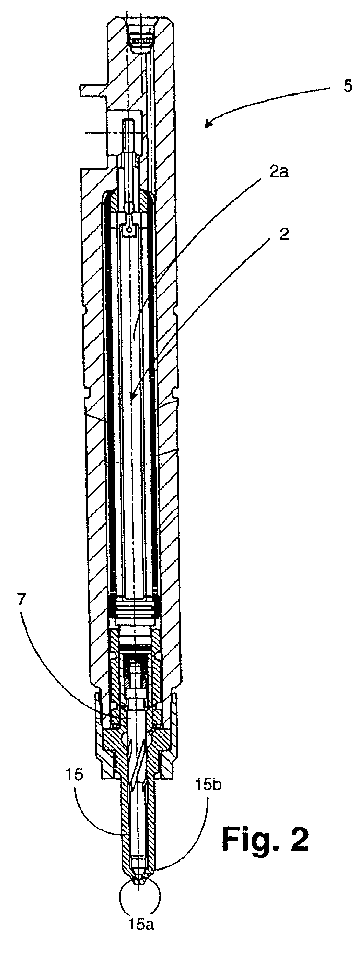

Figure 1 is a schematic view of a piezoelectric actuator 2 of the type commonly used to actuate a valve needle of a fuel injector 5 (shown in Figure 2) for a compression-ignition internal combustion engine. The actuator 2 includes a poled piezoelectric stack 2a having a plurality of piezoelectric layers 4 separated by a plurality of internal electrodes forming positive and negative electrode groups 6a and 6b, respectively.
Figure 1 is illustrative only and in practice the stack 2a would include a greater number of layers 4 and electrodes 6a, 6b than those shown. Arrows, exemplified by arrows 4a and 4b, between adjacent interdigitated electrodes 6a, 6b indicate the dominant direction of remanent polarisation of the dipoles contained in the piezoelectric layers 4; wherein, the arrow-head of each arrow 4a, 4b indicates the position of the negative pole of each dipole, and the arrow-tail indicates the position of the positive pole of each dipole. The arrows are illustrative only and in practice there would be many more dipoles than indicated in the figures.

The electrodes of the positive group 6a are interdigitated with the electrodes of the negative group 6b, with the electrodes of the positive group 6a connecting with a positive external electrode 8a and the electrodes of the negative group 6b connecting with a negative external electrode 8b. The positive and negative external electrodes 8a, 8b receive an applied voltage, in use, that produces an intermittent electric field between adjacent interdigitated electrodes 6a, 6b. The intermittent electric field rapidly varies with respect to its strength. In turn, this causes the stack 2a to extend and contract along the direction of the applied field.

A lower end cap 10b is adjacent to the lowermost piezoelectric layer 4 of the stack 2a and an upper end cap 10a is adjacent to the uppermost piezoelectric layer 4 of the stack 2a. The lower end cap 10b is coupled to an injector valve needle 7 (shown in Figure 2), either directly or through an intermediate mechanical and/or hydraulic coupling. Thus, as the stack 2a extends and contracts upon application of the electric field, the injector valve needle 7 is caused to move to control injection of pressurised fuel into an associated engine cylinder (not shown).

Referring to Figure 2, in order to prevent injection of fuel into the cylinder, the injector valve needle 7 securely abuts an injector nozzle seating 15b; thereby preventing fuel from passing through fuel channels 15a in the nozzle 15. This is achieved by applying a voltage of, for example, 200V to the electrodes of the positive group 6a which causes the stack 2a to extend. The electrodes of the negative group 6b are maintained at 0V. Due to fuel injection taking a relatively short period of time, the fuel injector valve needle 7 is engaged with the associated seating 15b in the aforementioned manner for approximately 95% of the fuel injector's operating cycle.

To inject fuel into the cylinder, the voltage applied to the electrodes of the positive group 6a is rapidly reduced, thereby causing the stack 2a to contract. The amount that the voltage is reduced is dependent on the pressure of the fuel. For example, at a minimum pressure of around 200bar (such as when the engine is idling) the voltage applied to the electrodes of the positive group 6a will drop to 20V, and at a maximum pressure of around 2000bar the voltage applied to the electrodes of the positive group 6a will drop to -20V, briefly making the electrodes of the positive group 6a negative.

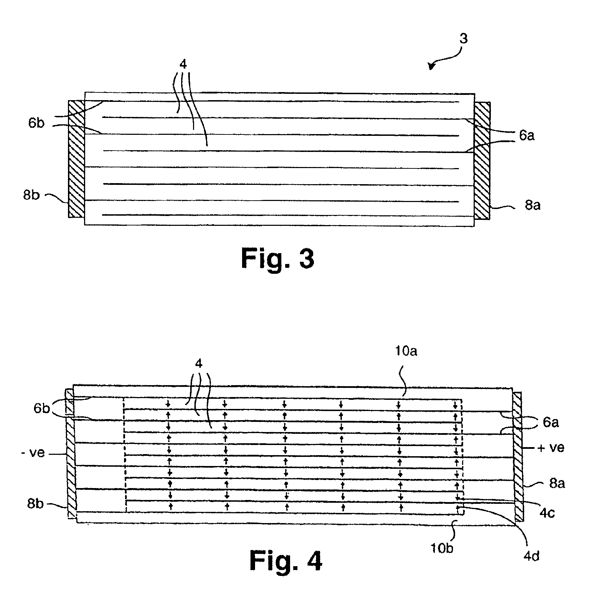

In order for the piezoelectric actuator 2 to behave in the aforementioned manner, it is necessary to pole the piezoelectric stack 2a. One known process of poling the piezoelectric stack 2a will be described with reference to Figures 3 to 5.

An example of an unpoled multilayer ferroelectric sample of which the piezoelectric stack 2a is comprised is shown schematically in Figure 3. A multilayer structure 3 is formed from a plurality of relatively thin ferroelectric ceramic layers 4, as in Figure 1. An example of a ferroelectric material is lead zirconate titanate, also known by those skilled in the art as PZT.

The multilayer structure 3 is poled by applying a potential difference across the positive and negative external electrodes 8a, 8b which, in turn, apply the potential difference across the internal groups of positive and negative electrodes 6a, 6b. In order to achieve poling of the dipoles contained within the piezoelectric material, the dipoles must be exposed to an electric field large enough to cause permanent crystallographic realignment and dipole reorientation. The minimum electric field strength necessary to affect this change is referred to as the "coercive" field strength. Due to the alternating polarity of the internal electric field, the poling direction of the dipoles within the piezoelectric material alternates throughout the structure, as indicated by the arrows, exemplified by arrows 4c and 4d, orthogonal to the internal groups of positive and negative electrodes 6a, 6b in Figure 4.

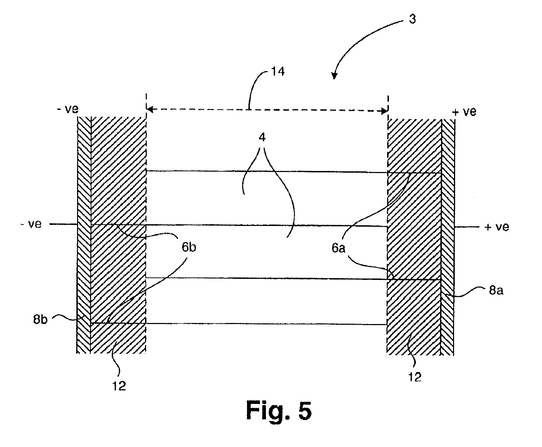

A ferroelectric multilayer will only be poled where it is exposed to the coercive electric field. As shown in Figure 5, once the coercive field has been applied to the multilayer structure 3, the central regions of the ferroelectric layers 4 contained between adjacent oppositely charged electrodes 6a, 6b (shown as central region 14) are poled. The central region 14 is also known as the active zone.

In order to avoid a short circuit, each electrode of the internal groups of positive and negative electrodes 6a, 6b is terminated such that it does not contact the respective external electrode of the opposite polarity 8a, 8b. Thus, on either side of the central region 14 there is defined a side region 12 which forms an isolation zone (or margin). The side regions 12 are also known as the inactive zone. Accordingly, the ends of the piezoelectric layers 4 contained in the side regions 12 are not subjected to an electric field because adjacent electrodes in these regions are at the same potential; thus, the piezoelectric material in the side regions 12 remains unpoled. This gives rise to a ferroelectric strain discontinuity between the regions of poled and unpoled ceramic, placing the unpoled material in tension and the poled material in compression. This is because, when a ferroelectric material is poled, the crystallographic realignment creates a permanent elongation along the axis of the applied field, known as "ferroelectric strain". In the multilayer structure 3 this elongation only occurs within the interdigitated central region 14. As a result, the poled material is clamped, which may adversely affect the actuator stroke, i.e. some clamping force may increase the stroke relative to zero load conditions, whereas a very high clamping force will reduce the stroke. Longitudinal distortion may occur if the clamping of the poled material by the unpoled material in the side regions 12 is not uniform. Furthermore, the unpoled material tends to fracture and crack due to the tensile forces created within it by the elongation of the central region 14. These cracks are called "poling cracks".

The poling cracks are of different types. Some poling cracks form parallel to the plane of inner electrodes 6a, 6b, and are known as "parallel poling cracks", whereas some deviate from the inner electrode plane direction, and are known as "deviated poling cracks". The parallel poling cracks 13 are the most common type of poling cracks and a number of such cracks are identified in Figure 1. Typically, the parallel poling cracks 13 form at the interface between an inner electrode and the adjacent ferroelectric layer 4. The deviated poling cracks 16 are the most dangerous cracks since they can potentially link inner electrodes of opposite polarities. This can lead to failure of the piezo stack by dielectric breakdown in the deviated crack.

When the actuator is in use, the deviated cracks 16 are worsened due to the repeated tensile strain imposed by the rapidly intermittent electric field which further fatigues the composite structure in the side regions 12. In addition to the temporary elongation of the stack 2a produced by the intermittent field, the permanent and temporary straining of the poled central region 14 causes the end caps 10a, 10b to experience lateral compression and bending which manifests itself as doming of the end caps 10a, 10b; illustrated in Figure 1.

Ferroelectric materials and their associated poling are discussed further in the Applicant's granted European patent number 1 516 373.

It is an object of the present invention to provide a method of poling a sample of ferroelectric material which removes or alleviates the aforementioned problems.

### Summary of Invention

According to a first aspect of the invention, there is provided a method of poling a ferroelectric sample suitable for use in a fuel injector of an internal combustion engine, the method comprising;
providing a ferroelectric sample having a stack of ferroelectric layers, wherein adjacent layers are separated by internal electrodes, forming a first group and a second group of electrodes;
applying a multiaxial pressure to the ferroelectric sample;
reducing the bonding strength between respective adjacent pairs of ferroelectric layers and internal electrodes; and
generating a first electric field between the first and second group of electrodes to pole each ferroelectric layer in a first poling direction.

Thus, by reducing the ferroelectric layer/electrode bonding strength prior to poling the ferroelectric sample, the generation of deviated poling cracks can be significantly reduced or eliminated. Accordingly, the possibility of a short circuit occurring between adjacent inner electrodes is reduced.

In one embodiment, the step of reducing the bonding strength may include applying a first negative voltage to said first group of electrodes; removing said first negative voltage; applying a second negative voltage to said second group of electrodes; and removing said second negative voltage before generating said first electric field between the first and second groups of electrodes.

Alternatively, the step of reducing the bonding strength may include generating a second electric field between the first and second group of electrodes to pole the each ferroelectric layer in an operational poling direction, opposite to said first poling direction.

Advantageously, the method comprises positioning the ferroelectric sample within the fuel injector before generating the electric field between the first and second groups of electrodes. This provides a convenient way of applying a multiaxial pressure to the sample, for example by way of a hydrostatic load generated by high pressure fluid in which the sample is immersed. It is preferred, although not essential, that the fluid is fuel, e.g. diesel fuel which is used with the injector.

In order to ensure that the generation of cracks is minimised, said multiaxial pressure may be greater than 1500 bar. However, a higher multiaxial pressure, for example approximately 2000 bar, should ensure a higher degree of crack elimination.

Conveniently, the first and second groups of electrodes are interdigitated.

### Brief Description of Drawings

Embodiments of the present invention will now be described, by way of example only, with reference to the accompanying drawings, in which;
Figure 1 illustrates a poled piezoelectric actuator for use in a fuel injector comprising piezoelectric layers separated by interdigitated electrodes;
Figure 2 illustrates a fuel injector for an internal combustion engine of the type in which the piezoelectric actuator of Figure 1 may be employed;
Figure 3 illustrates an unpoled multilayer ferroelectric sample of which the actuator of Figure 1 is comprised;
Figure 4 illustrates the multilayer ferroelectric sample of Figure 3 after poling, with the poling direction of the dipoles shown schematically throughout the sample;
Figure 5 is an enlarged view of a part of the multilayer sample of Figures 3 and 4;
Figure 6 illustrates a piezoelectric actuator, similar to the actuator of Figure 1, during poling according to an embodiment of the present invention, with the poling direction of the dipoles shown schematically throughout the sample;
Figure 7 is a flowchart showing an embodiment of the invention; and
Figure 8 is a flowchart showing an alternative embodiment of the invention.

### Detailed Description of Preferred Embodiments

It has been ascertained that an important factor which determines the type of crack formed during the poling is the relationship between the strength of the piezo ceramic material itself, and the strength of the bonding between the piezo ceramic material and the inner electrodes 6a, 6b. More specifically, the deviated cracks 16 occur mainly when the strength of the adhesion between inner electrodes and the piezo ceramic is in the same range as the strength of the ceramic itself. Therefore, the method according to the first embodiment of the present invention seeks to decrease the adhesion strength of the inner electrodes 6a, 6b to the piezo ceramic layers 4.

Adhesion of each inner electrode to the adjacent ceramic layer 4 is a result of the link or bond between a metal atom of the inner electrode (Silver and/or Palladium) and an oxygen atom of the PZT material. More specifically, the links are Pd-O-Pb or Ag-O-Pb. Thus, a decrease in the number of these links will lower the strength of the electrode bonding and will decrease/eliminate the generation of the deviated cracks during poling. This can be achieved by applying a voltage to an inner electrode, facilitating the rupture of the Ag-O or Pd-O bonding by an electrochemical reaction. Such a reaction occurs when the inner electrode is at the negative side, thereby bringing the necessary electrons.

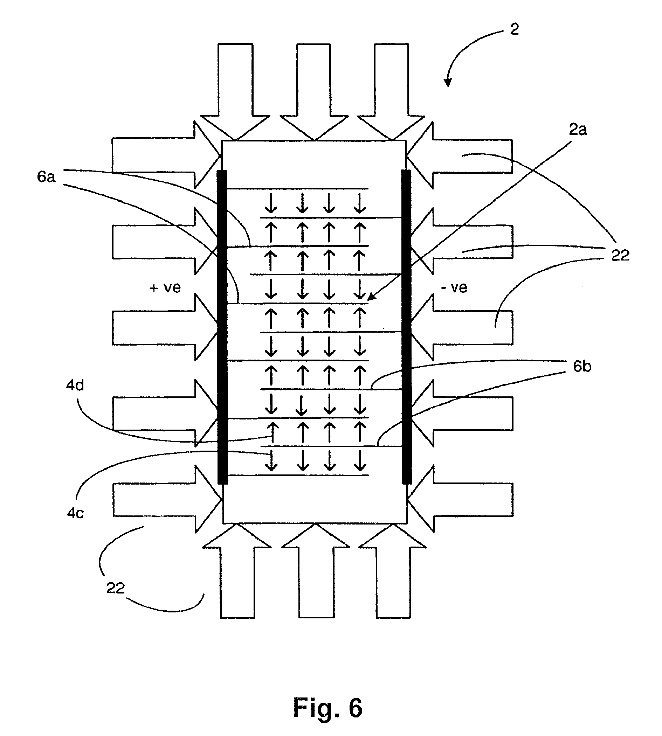

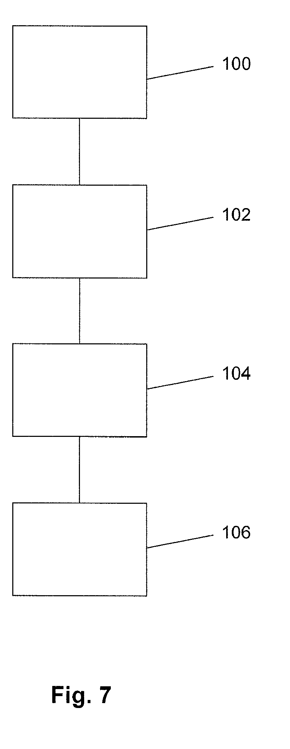

In a first embodiment of the present invention, as shown in Figures 6 and 7, the piezoelectric stack 2a is subjected to a multiaxial force over its entire surface during the poling process, as indicated by arrows 22 in Figure 6, and poled using a single-stage poling process. This multiaxial force may be applied to an encapsulated actuator by way of housing the actuator within a chamber containing pressurised diesel fuel within an assembled fuel injector. In this way, it is possible to subject the stack 2a to a hydrostatic loading up to the maximum system pressure (typically -2000 bar) of the fuel injection system in which the injector is installed. The hydrostatic loading applied to the stack 2a is chosen to be above a given level, where poling cracks are not generated. From testing, this threshold level has been found to be in the range of 1000 ± 300 bar. Accordingly, the poling method according to the first embodiment may be carried out with a hydrostatic pressure in excess of 1500 bar. Note that this first step of applying a multi axial load to the actuator which, in this embodiment, is attained via a hydrostatic pressure, is illustrated by step 100 in the flowchart of Figure 7.

Next, a negative voltage is applied sequentially to each of the two groups of inner electrodes 6a, 6b in order weaken the bonds between the inner electrodes 6a, 6b and the respective adjacent piezoelectric ceramic layers 4. The negative voltage must be applied sequentially since it is not possible to apply the negative voltage to both groups of inner electrodes 6a, 6b at the same time. Note that step 102 represents the application of the negative voltage to the first group of inner electrodes 6a, and step 104 represents the application of a negative voltage to the second group of internal electrodes.

The loading condition and the magnitude and duration of the negative voltage applied to each of the groups of electrodes 6a, 6b are selected such that the electrode bonding weakening occurs for both polarities of inner electrode before any poling cracks are generated.

Subsequently, and as illustrated at step 106 in Figure 7, the stack 2a is poled conventionally. That is to say, a potential difference large enough to exceed the coercive electric field is applied across the internal positive and negative electrodes 6a, 6b. The coercive electric field strength is typically between 1 and 2 kV/mm. However, raising the temperature of the stack 2a during poling reduces the coercive field strength below 1 kV/mm.

Thus, by weakening the bonds between each of the inner electrodes and the respective adjacent piezoelectric ceramic layers 4 prior to poling the stack 2a, any poling cracks which are generated by the poling process will be of the of the type parallel to the plane of the inner electrodes. Accordingly, the risk of short circuit caused by a deviated crack propagating between two adjacent inner electrodes of opposite polarity is substantially eliminated.

In the above-described method, it is important that the axial loading on the stack 2a is such that the total strain-stress in all zones (active or inactive) will remain below the tensile rupture limit of the ceramic of the electrode bonding level. The application of a high uniaxial load (e.g. between 5000 and 10000 N) would be likely too high for the stack geometry, resulting in a risk of stack buckling or mechanical depoling.

In the case of mechanical depolarisation, the axial load will tend to flip all the PZT dipoles to the position where they have the minimum length, so that the system finds its state of lowest energy. When the dipoles are oriented at 90 degrees to the axis of electrical field there is no longer any strain due to the piezo effect (intrinsic piezo effect), because the dipole is not aligned with the field and thus the field cannot "stretch" the crystal. Furthermore, if the load is high enough, the electrical field will not be strong enough to flip the dipoles back in the direction of the field. The dipoles will remain mechanically locked at 90 degrees to the field direction. The result is that it is not possible to change the alignment of the dipoles in order to pole the sample. For the above reasons at least, applying an increased uniaxial load to the stack 2a as the sole technique to avoid cracks is not an option.

Accordingly, in the method according to the first embodiment at step 100, a multiaxial force in the form of a hydrostatic pressure (or isostatic) is applied to the stack 2a. With hydrostatic loading, it is possible to reach very high compression and still have the possibility of physically poling the stack 2a. This is because, with the hydrostatic loading, there is no preferential direction for the dipoles to take under loading alone. Thus, the application of a hydrostatic load above a given threshold level, in the range of 1000 to 1500 bar, ensures that no poling cracks are generated during the process of sequentially applying the negative voltage to the inner electrodes in order to weaken the bonds with the piezoelectric ceramic layers 4.

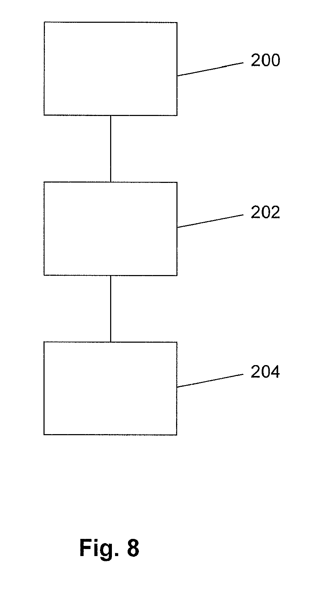

A second embodiment of a method of poling a ferroelectric sample will now be described with reference to Figure 6, and the flowchart of Figure 8. As in the case of the first embodiment, the piezoelectric stack 2a is subjected to a high hydrostatic pressure over its entire surface during the poling process as illustrated at step 200.

Next, as illustrated at step 202, a reverse poling voltage is applied to the stack 2a. More specifically, the reverse poling voltage has the same magnitude as the conventional poling voltage, but with the opposite polarity. Thus, a positive voltage is applied to the negative electrode 8b or, to the same effect, a negative voltage is applied to the positive external electrode 8a. The result is that the stack 2a is poled in reverse compared to the voltage it will see in operation.

Subsequently, as illustrated at step 204, a conventional poling voltage is applied to the stack 2a, i.e. a positive voltage is applied to the positive electrode 8a. When the conventional poling voltage is applied, the stack 2a is completely depoled and then repoled in the correct "final" polarity, which is the same as the polarity used in operation of the injector.

In the above-described method, it is important that the hydrostatic (or isostatic) pressure is sufficiently high in order to obtain the correct result. Isostatic poling at too low pressure, e.g. 500 bar, does not bring any advantage. However, pressure above a threshold level, in the range of 1000 to 1500 bar, has been found to be high enough to prevent crack generation.

Typically, the poling voltage applied is around 200 V and, accordingly the reverse poling voltage is around -200 V. This gives a nominal field in the PZT layers 4 of about 2.3 kV/mm. This is significantly higher than the voltage at which poling occurs (the coercive field voltage level), which is -70 to 80 V at room temperature. However, by applying a higher poling voltage it is possible not only to pole the stack 2a, but also to elongate the stack 2a to the maximum stroke, while subjected to the high isostatic loading level, in order to generate internal poling cracks of only one type, i.e. poling cracks parallel to the inner electrodes.

The time for which the reverse poling voltage is applied to the stack may be as little as 50 milliseconds.

By means of the method according to the second embodiment described above, it has been found that the generation of deviated poling cracks is significantly reduced or eliminated, although the exact physical mechanism by which this result is achieved is not fully understood.

An additional poling technique is substantially the same as the above-described second embodiment, with the exception that the step of applying the reverse poling voltage to the stack 2a is omitted. Accordingly, in the third embodiment, a very high isostatic load is applied to the stack 2a and, subsequently, the stack is poled in a conventional way.

## Claims

1. A method of poling a ferroelectric sample (2a) suitable for use in a fuel injector (5) of an internal combustion engine, the method comprising;
providing a ferroelectric sample (2a) having a stack of ferroelectric layers (4), wherein adjacent layers (4) are separated by internal electrodes (6a, 6b), forming a first group (6a) and a second group (6b) of electrodes;
applying a multiaxial pressure to the ferroelectric sample;
reducing the bonding strength between respective adjacent pairs of ferroelectric layers (4) and internal electrodes (6a, 6b); and
generating a first electric field between the first (6a) and second (6b) group of electrodes to pole each ferroelectric layer (4) in a first poling direction.

2. A method according to claim 1, wherein reducing said bonding strength comprises;
applying a first negative voltage to said first group of electrodes (6a);
removing said first negative voltage;
applying a second negative voltage to said second group of electrodes (6b); and
removing said second negative voltage before generating said first electric field between the first (6a) and second (6b) groups of electrodes.

3. A method according to claim 1, further comprising;
generating a second electric field between the first (6a) and second (6b) group of electrodes to pole each ferroelectric layer (4) in an operational poling direction, opposite to said first poling direction.

4. A method according to any preceding claim, comprising positioning the ferroelectric sample (2a) within the fuel injector (5) before generating the electric field between the first (6a) and second (6b) groups of electrodes.

5. A method according to any preceding claim, wherein said multiaxial pressure comprises a hydrostatic load applied by means of a fluid.

6. A method according to any preceding claim, wherein the fluid is a fuel, for example diesel.

7. A method according to any preceding claim, wherein said multiaxial pressure is greater than 1500 bar.

8. A method according to claim 9, wherein said multiaxial pressure is approximately 2000 bar.

9. A method according to any preceding claim, wherein the first (6a) and second (6b) groups of electrodes are interdigitated.
